# DEMANDE DE BREVET EUROPEEN

(11) **EP 3 466 567 A1**
(43) Date de publication de la demande: **10.04.2019**
(21) Numéro de dépôt: 18195375.3
(22) Date de dépôt: 19.09.2018
(51) Int. Cl.: B22F 3/105, C22C 1/04, B33Y 70/00, B33Y 10/00, F01D 25/24

(54) **PROCÉDÉ DE FABRICATION D'UNE PIÈCE COMPRENANT DEUX SUPERALLIAGES DIFFÉRENTS**

(30) Priorité: 25.09.2017 FR 1758825
(71) Demandeur: SAFRAN AIRCRAFT ENGINES, 75015 Paris (FR)
(72) Inventeur: POUZET, Sébastien Yohann, 77550 MOISSY-CRAMAYEL (FR); SEINCE, Hervé Antoine Frédéric, 77550 MOISSY-CRAMAYEL (FR); CASTAGNE, Jean-François, 55770 MOISSY-CRAMAYEL (FR)
(74) Mandataire: Cabinet Beau de Loménie

(57) **Abrégé**

L'invention concerne un procédé de fabrication d'une pièce (10) en superalliage, la pièce comportant une première portion (12) comprenant majoritairement en masse un premier superalliage (A) et une deuxième portion (14) comprenant majoritairement en masse un deuxième superalliage (B) différent du premier superalliage, la deuxième portion s'étendant à partir de la première portion, le procédé comprenant le dépôt de la deuxième portion sur une surface (18) de la première portion par un procédé de dépôt direct de métal (DMD), le dépôt de la deuxième portion comprenant au moins le dépôt d'une première couche (16a) sur ladite surface, puis le dépôt d'une deuxième couche (16b) sur la première couche, la première couche comprenant du premier et du deuxième superalliage, la première couche présentant une teneur massique en premier superalliage strictement supérieure à celle de la deuxième couche et strictement inférieure à celle de la première portion, la deuxième couche présentant une teneur massique en deuxième superalliage strictement supérieure à celle de la première couche.

## Description

### Arrière-plan de l'invention

La présente invention se rapporte au domaine général des procédés de fabrication de pièces en superalliage. L'invention s'applique plus particulièrement, mais non exclusivement, à la fabrication d'un carter de turbine en superalliage comprenant par exemple une portion d'accrochage d'un secteur d'anneau ou une portion d'étanchéité s'étendant radialement vers l'intérieur dudit carter.

Une turbomachine aéronautique comprend généralement une partie dite chaude, située en aval des chambres de combustion (l'amont et l'aval sont définis par rapport au sens d'écoulement du flux gazeux dans la turbomachine), comprenant une turbine haute pression et une turbine basse pression. De façon connue, la turbine haute pression comprend un arbre de rotor haute pression qui entraîne en rotation le compresseur haute pression situé à l'amont, et la turbine basse pression comprend un arbre de rotor basse pression qui entraîne en rotation la soufflante et le compresseur basse pression.

Les turbines sont délimitées radialement à l'extérieur par un carter de turbine. Le carter de turbine comprend une portion principale annulaire, sectorisée ou non, et peut comporter en outre des portions secondaires formant des portions d'étanchéités, ou des portions d'accrochage d'un secteur d'anneau, par exemple des bossages, des brides ou des crochets, qui s'étendent à partir d'une face interne de celui-ci radialement vers l'intérieur de la veine de circulation des gaz chauds. De telles portions secondaires sont soumises à des températures plus élevées que la portion principale du carter située en périphérie de veine. Les portions secondaires doivent ainsi être fabriquées dans un matériau apte à supporter les contraintes thermomécaniques importantes qui leur sont imposées. Les besoins en termes de tenue mécanique et à la température entre la portion principale du carter et les portions secondaires sont donc différents.

De façon connue, on utilise pour les pièces de la turbine des superalliages, par exemple à base de nickel. Pour fabriquer le carter précité d'un seul tenant, on doit généralement former la portion principale annulaire et les portions secondaires dans le même matériau, ce qui peut alors s'avérer couteux puisqu'il faudra utiliser le superalliage le plus performant pour toute la pièce. En effet, les superalliages performants capables de tenir la température à l'intérieur de la veine sont généralement plus couteux et difficiles à mettre en oeuvre lors de la fabrication que ceux qui sont suffisants pour former la partie annulaire du carter. En outre, il est souvent difficile de travailler par fonderie les superalliages performants qui supportent les conditions environnementales à l'intérieur de la veine.

Il existe donc un besoin pour un procédé de fabrication peu couteux et de mise en oeuvre aisée qui permette d'obtenir une pièce comprenant plusieurs portions en superalliages différents.

### Objet et résumé de l'invention

La présente invention a donc pour but principal de pallier de tels inconvénients en proposant un procédé de fabrication d'une pièce en superalliage, la pièce comportant une première portion comprenant majoritairement en masse un premier superalliage et une deuxième portion comprenant majoritairement en masse un deuxième superalliage différent du premier superalliage, la deuxième portion s'étendant à partir de la première portion, le procédé comprenant le dépôt de la deuxième portion sur une surface de la première portion par un procédé de dépôt direct de métal (DMD), le dépôt de la deuxième portion comprenant au moins le dépôt d'une première couche sur ladite surface, puis le dépôt d'une deuxième couche sur la première couche, la première couche comprenant du premier et du deuxième superalliage, la première couche présentant une teneur massique en premier superalliage strictement supérieure à celle de la deuxième couche et strictement inférieure à celle de la première portion, la deuxième couche présentant une teneur massique en deuxième superalliage strictement supérieure à celle de la première couche.

En d'autres termes, la deuxième portion comprend du premier et du deuxième superalliage, et peut présenter un gradient de composition entre le premier superalliage et le deuxième superalliage tel que la teneur massique en premier superalliage diminue et la teneur massique en deuxième superalliage augmente en s'éloignant de la surface de la première portion sur laquelle la deuxième portion est déposée. Par procédé de dépôt direct de métal (DMD pour « Direct Metal Déposition »), on entend un procédé de fabrication additive dans lequel une tête de dépôt comprend un faisceau énergétique (par exemple un faisceau d'électrons ou un laser) qui rencontre un fil de métal ou un flux de poudre métallique focalisé afin de faire fondre le métal, et de déposer les gouttes de métal ainsi fondu pour former un bain de métal fondu sur une surface. Le refroidissement du bain permet de former progressivement une couche. La tête de dépôt peut se déplacer pour former couche par couche la portion de pièce à fabriquer. Le procédé DMD est aussi connu sous le vocable anglais « Direct Energy Déposition » (DED).

Par « majoritairement en masse », on entend une teneur massique d'au moins 50%. Dans un exemple de réalisation, la première portion comprend au moins 75% en masse de premier superalliage, voire au moins 90% en masse. Dans un exemple de réalisation, la deuxième portion comprend au moins 75% en masse de deuxième superalliage, voire au moins 90% en masse.

La première et/ou la deuxième couche peuvent comprendre chacune une pluralité de sous-couches de teneurs massiques en premier et en deuxième superalliage identiques. En particulier, l'étape de dépôt de la première et/ou l'étape de dépôt de la deuxième couche peuvent chacune comprendre le dépôt d'une pluralité de sous-couches de teneurs massiques en premier et en deuxième superalliage identiques. Le dépôt d'une couche peut, en d'autres termes, être réalisé par plusieurs passages successifs d'une tête de dépôt, chaque passage permettant le dépôt d'une sous-couche.

Le procédé selon l'invention est avantageux en ce qu'il permet d'obtenir une pièce monobloc comportant deux portions comprenant des superalliages différents, en utilisant le procédé DMD, simple à mettre en oeuvre. On peut ainsi utiliser par exemple un superalliage plus couteux et présentant de meilleures propriétés thermomécaniques pour la deuxième portion, et un superalliage plus économique et facile à fabriquer pour la première portion. Le procédé selon l'invention est notamment rendu possible grâce à la présence de la première et de la deuxième couche de la deuxième portion, qui jouent le rôle de couches d'accommodation entre le premier superalliage et le deuxième superalliage. En d'autres termes, un gradient de composition est présent entre la première portion et la deuxième portion grâce à ces première et deuxième couches. La compatibilité thermomécanique entre la première portion et la deuxième portion est ainsi améliorée. Aussi, le procédé selon l'invention permet de fabriquer par DMD une deuxième portion de forme complexe sur une première portion déjà fabriquée, elle aussi pouvant présenter une forme complexe.

Dans un exemple de réalisation, le dépôt de la deuxième portion peut comprendre le dépôt d'une troisième couche sur la deuxième couche, la troisième couche présentant une teneur massique en premier superalliage strictement inférieure ou nulle à la celle de la deuxième couche, et une teneur massique en deuxième superalliage strictement supérieure à celle de la deuxième couche. Cela permet de rendre encore plus progressif le gradient de composition entre la première portion et la deuxième portion, pour améliorer encore la compatibilité thermomécanique entre les deux portions. Bien entendu, la deuxième portion peut comprendre un nombre plus élevé de couches selon sa taille et sa forme.

Dans un exemple de réalisation, le premier et le deuxième superalliages peuvent être des superalliages à base de nickel présentant des teneurs massiques non nulles en titane et en aluminium, la somme des teneurs massiques en aluminium et en titane dans le premier superalliage étant strictement inférieure à 3%, et la somme des teneurs massiques en aluminium et en titane dans le deuxième superalliage étant supérieure ou égale à 3%. Par « à base de nickel », on entend que la teneur massique en nickel dans l'alliage est supérieure ou égale à 50%. La famille de premiers superalliages répondant à cette définition présente l'avantage d'être moins couteuse et plus facile à mettre en oeuvre que la famille de deuxièmes superalliages répondant à cette définition. La famille de deuxièmes superalliages répondant à cette définition présente également des caractéristiques thermomécaniques améliorées par rapport à la famille de premiers superalliages répondant à cette définition.

Dans un exemple de réalisation, le premier superalliage peut être un superalliage à base de nickel présentant une teneur massique en aluminium comprise entre 0,1% et 0,9% et une teneur massique en titane comprise entre 0,5% et 2,5%, et le deuxième superalliage est un superalliage à base de nickel présentant une teneur massique en aluminium comprise entre 1% et 4,8% et une teneur massique en titane comprise entre 2,6% et 4%.

De manière générale, le premier superalliage peut être de tout type connu, par exemple à base de cobalt, de fer, de titane ou d'aluminium.

Dans un exemple de réalisation, le premier superalliage peut être choisi parmi les références commerciales suivantes : C-263, Inconel® 718.

Dans un exemple de réalisation, le deuxième superalliage peut être choisi parmi les références commerciales suivantes : Waspaloy®, Inconel® 738.

Dans un exemple de réalisation, durant l'étape de dépôt de la deuxième portion sur la surface de la première portion de la pièce, ladite surface peut être chauffée à une température comprise entre 400°C et 800°C. En chauffant ainsi la surface sur laquelle le dépôt est réalisé, on réduit les risques de fissuration et on contrôle mieux la solidification du métal au cours de l'étape de dépôt de la deuxième portion par DMD. La température doit être suffisamment élevée pour éviter les fissurations dues à un gradient trop de température trop important, et ne pas être trop élevée pour éviter la dégradation du superalliage.

Dans un exemple de réalisation, la surface de la première portion peut être chauffée par induction. Cette disposition avantageuse permet de cibler le chauffage seulement là où la deuxième portion sera déposée sur la première portion. On pourra par exemple utiliser un inducteur circulaire positionné à proximité de la surface sur laquelle le dépôt sera effectué.

La première portion de la pièce constitue une partie au moins d'un carter de turbine à gaz et la deuxième portion de la pièce peut constituer une portion d'accrochage d'un secteur d'anneau ou une portion d'étanchéité, la deuxième portion s'étendant radialement vers l'intérieur dudit carter. En particulier, la première portion peut constituer un carter en une seule pièce ou sectorisé. Une portion d'accrochage peut constituer par exemple une bride, un crochet ou un bossage.

Dans un exemple de réalisation, on peut déposer la deuxième portion par dépôt de métal par laser (LMD) ou par faisceau d'électron (EBMD).

Dans un exemple de réalisation, la première portion de la pièce peut être obtenue par fonderie ou par fabrication additive.

Dans un exemple de réalisation, la première portion de la pièce peut être obtenue par forge.

Dans un exemple de réalisation, le dépôt de la deuxième portion sur une surface de la première portion est réalisé à partir d'une poudre. En particulier, pour former les couches présentant des teneurs massiques en premier et deuxième superalliage différentes, on pourra utiliser un mélange de poudres contrôlé. En variante, on peut réaliser le dépôt de la deuxième portion à partir d'un ou plusieurs fils métalliques.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 est une vue schématique montrant une turbomachine aéronautique,
- les figures 2A et 2B montrent une vue en coupe d'une partie d'un carter de turbine de turbomachine obtenu par un procédé selon un mode de réalisation de l'invention, et
- les figures 3A à 3D illustrent différentes étapes selon un mode de réalisation de l'invention.

### Description détaillée de l'invention

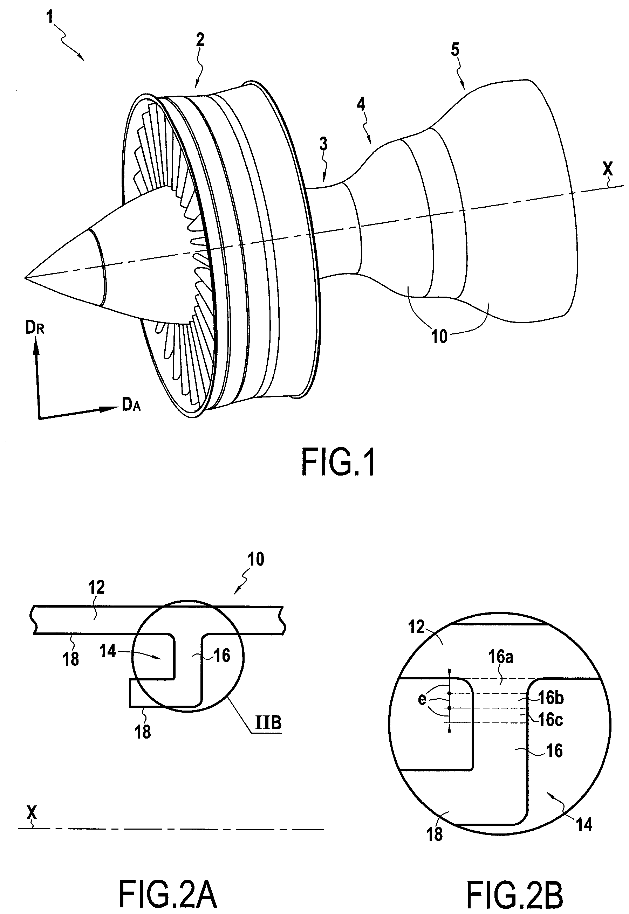

La figure 1 montre de façon très schématique une turbomachine aéronautique 1, par exemple un turboréacteur à double flux qui comprend, de l'amont vers l'aval dans le sens d'écoulement du flux gazeux dans la turbomachine : une soufflante 1 disposée en entrée de la turbomachine, un compresseur 2, une chambre de combustion 3, une turbine haute-pression 4 et une turbine basse pression 5. Les turbines haute-pression et basse-pression sont couplées respectivement au compresseur 2 et à la soufflante 1 par des arbres coaxiaux respectifs. La turbomachine 1 est ainsi centrée sur un axe X sur lequel sont également centrés les arbres coaxiaux précités. Les directions axiale DA et radiale DR, ainsi que les termes relatifs « intérieur », « extérieur » et leurs dérivés, sont définis par rapport à cet axe X.

La turbomachine est logée à l'intérieur d'un carter comprenant plusieurs parties correspondant à différents éléments du moteur. Ainsi, chacune des turbines haute-pression 4 et basse-pression 5 est entourée par un carter de turbine 10. La présente invention sera illustrée dans son application à la fabrication d'un de ces carters de turbine 10. On notera que l'invention peut s'appliquer à toute pièce nécessitant l'usage de matériaux différents dans différentes portions de celle-ci soumises à des contraintes thermomécaniques différentes.

La figure 2A montre une vue très schématique en coupe d'un carter de turbine 10 pouvant être obtenu par un procédé selon l'invention, par exemple un carter de turbine haute-pression 4 ou basse-pression 5 de turbomachine aéronautique 1 (seule une moitié du carter 10 a été représentée pour des raisons de concision). Le carter 10 comprend une première portion 12, ici une paroi de forme annulaire, et une deuxième portion 14 qui s'étend à partir de la première portion 12. La deuxième portion 14 constitue ici un crochet auquel on peut par exemple fixer un secteur d'anneau de turbine ou d'autres accessoires. La deuxième portion 14 s'étend radialement vers l'intérieur à partir d'une face interne 18 de la première portion 12 du carter. La deuxième portion 14 comprend ici une portion radiale 16 et une portion axiale 18. La première portion 12 du carter 10 obtenu par un procédé selon l'invention comprend majoritairement en masse un premier superalliage, alors que la deuxième portion 14 du carter 10 comprend majoritairement en masse un deuxième superalliage, différent du premier. Dans cet exemple précis, il pourra être avantageux d'utiliser un deuxième superalliage plus performant que le premier superalliage en termes de tenue à la température et aux contraintes mécaniques imposées dans la veine.

Dans cet exemple, le premier superalliage peut être un superalliage à base de nickel choisi parmi les références commerciales suivantes : C-263, Inconel® 718. Le deuxième superalliage peut être quant à lui choisi parmi les superalliages à base de nickel ayant l'une des références commerciales suivantes : Waspaloy®, Inconel® 738. Le tableau ci-dessous indique les gammes de teneurs massiques en aluminium et en titane de ces superalliages commerciaux à base de nickel.

| **premier superalliage** | **aluminium (%m)** | **titane (%m)** |
|---|---|---|
| C-263 | 0,3 - 0,6 | 1,9 - 2,4 |
| Inconel® 718 | 0,2 - 0,8 | 0,65 - 1,15 |

| **deuxième superalliage** | **aluminium (%m)** | **titane (%m)** |
|---|---|---|
| Waspaloy® | 1,2 - 1,6 | 2,75 - 3,25 |
| Inconel® 738 | 3,2 - 3,7 | 3,2 - 3,7 |

La figure 2B est une vue agrandie de la figure 2A au niveau de la deuxième portion 14. On a représenté trois couches de la portion radiale 16 : une première couche 16a, une deuxième couche 16b, et une troisième couche 16c. La deuxième portion 14 comprend ainsi au moins les première 16a, deuxième 16b et troisième 16c couches. La première couche 16a est la couche qui lie la première 12 et la deuxième portions 14, la deuxième couche 16b est située entre les première 16a et troisième 16c couches. Conformément à l'invention, la première couche 16a comprend du premier et du deuxième superalliage, c'est-à-dire une teneur massique non nulle en ces deux superalliages, et présente une teneur massique en en premier superalliage strictement supérieure à celle de la deuxième couche 16b et strictement supérieure à celle de la première portion 12 ; la deuxième couche 16b présente une teneur massique en deuxième superalliage strictement supérieure à celle de la première couche ; et la troisième couche 16c présente une teneur massique en premier superalliage strictement inférieure à celle de la deuxième couche 16b ou nulle et une teneur massique en deuxième superalliage strictement supérieure à celle de la deuxième couche. Les couches 16a-16c permettent ainsi de disposer d'un gradient de composition plus ou moins progressif dans la deuxième portion 14 à proximité de sa jonction avec la première portion 12. Cela permet de réduire fortement les problèmes de compatibilité thermomécanique entre la première 12 et la deuxième 14 portions qui peuvent être en des matériaux présentant des performances et des propriétés différentes, notamment de résistance au fluage ou de dilatation sous l'effet de la température.

Dans l'exemple illustré, l'épaisseur e de chacune des couches 16a-16c peut être supérieure ou égale à 0,5 mm, par exemple être supérieure ou égale à 1 mm, de façon à ce que le gradient de composition s'étende sur une épaisseur au moins égale à 1,5 mm, par exemple supérieure ou égale à 3 mm. Dans l'exemple illustré, les couches 16a-16c présentent une épaisseur e équivalente, en variante elles peuvent être différentes. La deuxième portion 14 comprend ici d'autres couches directement situées sur la troisième couche 16c (non illustrées sur les figures), qui peuvent comprendre seulement du deuxième superalliage.

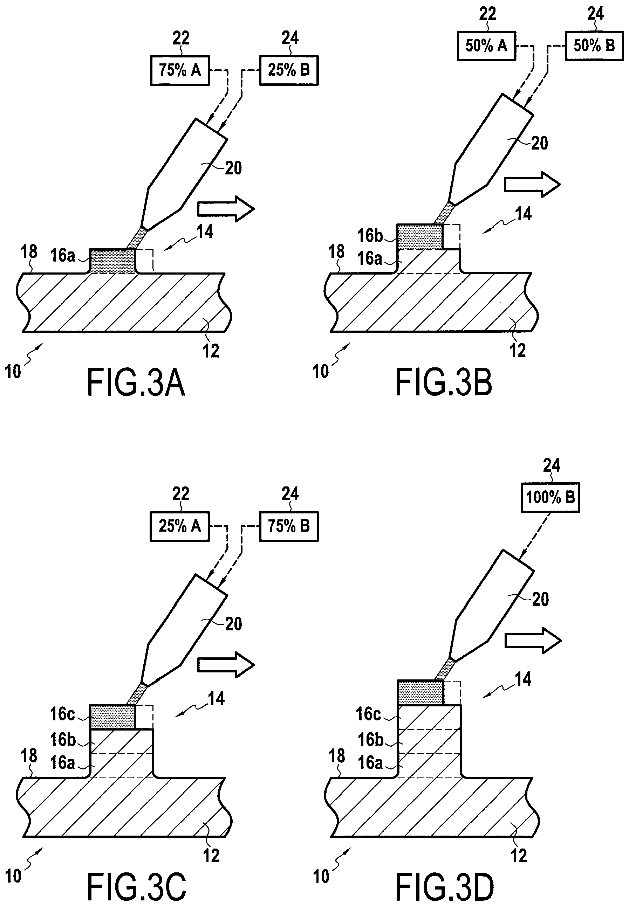

Les figures 3A à 3D illustrent les différentes étapes d'un procédé selon un mode de réalisation de l'invention, appliqué à la fabrication d'un carter 10 tel que celui présenté ci-avant.

On dispose tout d'abord de la première portion 12 du carter 10, qui peut avoir été obtenue par tous les moyens connus, par exemple par fabrication additive, par fonderie ou par forge.

Puis, on réalise le dépôt de la deuxième portion 14 sur la première portion 12, et plus particulièrement sur une surface 18 de la première portion 12. La surface 18 est, dans l'exemple illustré, située sur une face interne du carter 10. Pour déposer la deuxième portion 14, on utilise, conformément à l'invention, un procédé de dépôt direct de métal (DMD). Dans l'exemple illustré, on utilise un procédé de dépôt de métal par laser (LMD). Une tête de dépôt 20 est alimentée par un premier 22 et un deuxième 24 réservoirs de poudre métallique. Le premier réservoir 22 contient une poudre du premier superalliage A, alors que le deuxième réservoir 24 contient une poudre du deuxième superalliage B. La tête de dépôt 20 est ici configurée pour former un jet de poudre focalisé sur un faisceau laser de façon à déposer des gouttes de métal fondu. La tête de dépôt 20 est également configurée pour permettre de déposer un mélange des poudres contenues dans les réservoirs 22 et 24 afin de déposer des couches qui contiennent un mélange contrôlé des premier et deuxième superalliages A et B.

L'étape de dépôt de la deuxième portion 14 comprend le dépôt de la première couche 16a (figure 3A) sur la surface 18 de la première portion 12. Dans l'exemple illustré ici, la première couche 16a sera constituée de 75% en masse de premier superalliage A et de 25% en masse de deuxième superalliage B. Puis, l'étape de dépôt comprend aussi le dépôt de la deuxième couche 16b sur la première couche 16a (figure 3B). Dans l'exemple illustré ici, la deuxième couche 16b sera constituée de 50% en masse de premier superalliage A et de 50% en masse de deuxième superalliage B. Dans l'exemple illustré, on dépose encore une troisième couche 16c sur la deuxième couche 16b qui comprend un mélange des superalliages A et B. En particulier, la troisième couche 16c sera ici constituée de 25% en masse de premier superalliage A et de 75% en masse de deuxième superalliage B.

Enfin, la figure 3D montre le commencement du dépôt du reste de la deuxième portion 14, et notamment du reste de la portion radiale 16 de cette dernière. Pour continuer le dépôt de la deuxième portion 14, on peut ainsi utiliser seulement du deuxième superalliage B.

Au cours de l'étape de dépôt de la deuxième portion 14 sur la première portion 12, il peut être avantageux de chauffer la surface 18 sur laquelle le dépôt de la deuxième portion 14 est effectué pour contrôler le gradient de température et éviter que les couches ne refroidissent trop vite. On pourra par exemple chauffer la surface 18 à une température comprise entre 400°C et 800°C. Ce chauffage peut être réalisé par induction en positionnant un inducteur, par exemple un inducteur circulaire, autour de la surface 18 à chauffer.

Le procédé selon l'invention permet ainsi d'obtenir une pièce monobloc, c'est-à-dire qui se présente d'un seul tenant, comprenant des portions constituées de superalliages différents, de façon plus simple et économique qu'avec les procédés connus.

On notera que dans l'ensemble de l'exposé, pour des raisons de simplification, on a utilisé le terme « couche » pour désigner une zone de la pièce s'étendant selon une épaisseur donnée constituée d'un même matériau ou mélange de matériaux. Une couche peut ainsi être réalisée par plusieurs passages de la tête de dépôt lorsque cette dernière dépose toujours un même matériau ou mélange de matériaux.

Dans tout l'exposé l'expression « compris entre ... et ... » doit être entendue comme incluant les bornes.

## Revendications

1. Procédé de fabrication d'une pièce (10) en superalliage, la pièce comportant une première portion (12) comprenant majoritairement en masse un premier superalliage (A) et une deuxième portion (14) comprenant majoritairement en masse un deuxième superalliage (B) différent du premier superalliage, la deuxième portion s'étendant à partir de la première portion, le procédé comprenant le dépôt de la deuxième portion sur une surface (18) de la première portion par un procédé de dépôt direct de métal (DMD), le dépôt de la deuxième portion comprenant au moins le dépôt d'une première couche (16a) sur ladite surface, puis le dépôt d'une deuxième couche (16b) sur la première couche, la première couche comprenant du premier (A) et du deuxième (B) superalliages, la première couche présentant une teneur massique en premier superalliage strictement supérieure à celle de la deuxième couche et strictement inférieure à celle de la première portion, la deuxième couche présentant une teneur massique en deuxième superalliage strictement supérieure à celle de la première couche,
la première portion (12) de la pièce constituant une partie au moins d'un carter de turbine à gaz (10) et la deuxième portion (14) de la pièce constituant une portion d'accrochage d'un secteur d'anneau ou une portion d'étanchéité, la deuxième portion s'étendant radialement vers l'intérieur dudit carter.

2. Procédé selon la revendication 1, dans lequel le dépôt de la deuxième portion (14) comprend le dépôt d'une troisième couche (16c) sur la deuxième couche (16b), la troisième couche présentant une teneur massique en premier superalliage (A) strictement inférieure à la celle de la deuxième couche ou nulle, et une teneur massique en deuxième superalliage (B) strictement supérieure à celle de la deuxième couche.

3. Procédé selon la revendication 1 ou 2, dans lequel le premier (A) et le deuxième (B) superalliages sont des superalliages à base de nickel présentant des teneurs massiques non nulles en titane et en aluminium, la somme des teneurs massiques en aluminium et en titane dans le premier superalliage étant strictement inférieure à 3%, et la somme des teneurs massiques en aluminium et en titane dans le deuxième superalliage étant supérieure ou égale à 3%.

4. Procédé selon la revendication 3, dans lequel le premier superalliage (A) est un superalliage à base de nickel présentant une teneur massique en aluminium comprise entre 0,1% et 0,9% et une teneur massique en titane comprise entre 0,5% et 2,5%, et le deuxième superalliage (B) est un superalliage à base de nickel présentant une teneur massique en aluminium comprise entre 1% et 4,8% et une teneur massique en titane comprise entre 2,6% et 4%.

5. Procédé selon l'une quelconque des revendications 1 à 4, dans lequel, durant l'étape de dépôt de la deuxième portion (14) sur la surface (18) de la première portion (12) de la pièce, ladite surface est chauffée à une température comprise entre 400°C et 800°.

6. Procédé selon la revendication 5, dans lequel la surface (18) de la première portion (12) est chauffée par induction.

7. Procédé selon l'une quelconque des revendications 1 à 6, dans lequel on dépose la deuxième portion (14) par dépôt de métal par laser (LMD) ou par faisceau d'électron (EBMD).

8. Procédé selon l'une quelconque des revendications 1 à 7, dans lequel la première portion (12) de la pièce est obtenue par fonderie ou par fabrication additive.

9. Procédé selon l'une quelconque des revendications 1 à 7, dans lequel la première portion (12) de la pièce est obtenue par forge.
